# EUROPÄISCHE PATENTSCHRIFT

(11) **EP 1 051 887 B1**
(45) Veröffentlichungstag und Bekanntmachung des Hinweises auf die Patenterteilung: **24.10.2001**
(21) Anmeldenummer: 99907440.4
(22) Anmeldetag: 22.01.1999
(51) Int. Cl.: H05K 3/32, F16B 5/04, B29C 65/56, B29C 65/60

(54) **VERFAHREN ZUR HERSTELLUNG EINES EIN ELEKTRONIKBAUTEIL ENTHALTENDEN KUNSTSTOFFOBJEKTES**
PROCESS FOR PRODUCING A PLASTIC OBJECT CONTAINING AN ELECTRONIC COMPONENT
PROCEDE DE PRODUCTION D'UN OBJET PLASTIQUE CONTENANT UN COMPOSANT ELECTRONIQUE

(30) Priorität: 26.01.1998 CH 18098; 26.01.1998 CH 18198
(43) Veröffentlichungstag der Anmeldung: 15.11.2000
(73) Patentinhaber: Sempac SA, 6330 Cham (CH)
(72) Erfinder: RAGG, Wolfram, CH-6332 Hagendorn (CH); SACHER, Dieter, CH-5400 Baden (CH); TOBLER, Martin, CH-6003 Luzern (CH); BETSCHART, Alois, CH-6318 Walchwil (CH)
(74) Vertreter: Falk, Urs, Dr.
(86) Internationale Anmeldenummer: EP9900546
(87) Internationale Veröffentlichungsnummer: WO9938368

(56) Entgegenhaltungen:
- EP-A- 0 256 581
- DE-A- 2 607 875
- DE-A- 3 422 768
- DE-B- 1 294 647
- DE-C- 4 228 169
- FR-A- 683 029
- GB-A- 1 518 397
- US-A- 3 458 618
- US-A- 3 843 951
- US-A- 4 894 751
- US-A- 5 229 548

## Beschreibung

Die Erfindung betrifft ein Verfahren zur Herstellung eines ein Elektronikbauteil enthaltenden Kunststoffobjektes gemäss dem Oberbegriff des Patentanspruchs 1.

Unter dem Begriff Kunststoffobjekt sollen im Rahmen der vorliegenden Beschreibung Objekte verstanden werden, welche mindestens eine Folie und ein Elektronikbauteil, beispielsweise ein Elektronikmodul mit mindestens einem Halbleiterchip, und/oder einen Widerstand und/oder einen Kondensator und/oder einen Ferritkern enthalten. Das Kunststoffobjekt kann zudem fakultativ eine Leiterbahn enthalten. Als Beispiele für verhältnismässig flache derartige Kunststoffobjekte wie Chipkarten, bei denen die Folie in gegossenem, gespritztem, spritzgeprägtem Kunststoff eingebettet ist oder bei denen auf die Folie mindestens eine weitere Folie auflaminiert ist, sollen Kreditkarten, elektronische Schlüssel, Transporttickets und Tags genannt werden; als Beispiele für voluminösere Gegenstände werden wiederum Tags sowie Spielzeuge und mobile elektronische Kommunikationsgeräte angeführt. Die Kunststoffobjekte konnen starr oder flexibel sein, wobei für flexible Kunststoffobjekte nur flexible Leiterbahnen benutzt werden können, wenn die Leiterbahnen in einen zur flexiblen Deformation bestimmten Bereich des Kunststoffobjektes eingebaut werden. Als Beispiel eines sehr billigen Tags ist ein kontaktlos lesbares Tag erwähnt, das eine Folie mit einer als Antenne dienenden Leiterbahn und ein mit der Antenne verbundenes Elektronikbauteil sowie ein daran befestigtes doppelseitiges Klebband umfasst, mit dem das Tag an einem Gegenstand befestigt werden kann.

Unter dem Begriff eines Elektronikbauteiles sollen im Rahmen der vorliegenden Beschreibung Elektronikmodule, Ferritkerne Kondensatoren oder Widerstände verstanden werden.

Unter dem Begriff einer Leiterbahn sollen im Rahmen der vorliegenden Beschreibung starre oder flexible elektrisch leitende Teile insbesondere aus Kupfer oder einem anderen geeigneten Metall; aber auch in Leiterbahnstrukturen enthaltene Leiterbahnen verstanden werden, wobei die Leiterbahnen in den Leiterbahnstrukturen in einer oder mehreren durch Isolationen voneinander getrennten Schichten angeordnet sein können. Leiterbahnfolien welche Leiterbahnstrukturen bilden konnen anstelle oder zusatzlich zur genannten Folie verwendet werden; als Leiterbahnstrukturen kommen alle ublichen, dem Fachmann bekannten Leiterbahnstrukturen in Frage. Die Leiterbahnen können generell die Funktionen von Antennen übernehmen oder lediglich Verbindungszwecken dienen.

Bei den genannten Kunststoffobjekten wird eine Folie mit einem Elektronikbauteil in eine zur Bildung des Kunststoffobjektes vorgesehene Kunststoffmasse eingebettet und mit ihr verbunden. Während dieses Vorganges muss das Elektronikbauteil an der Folie fixiert oder mindestens so positioniert sein, dass es sich relativ zur Folie nicht verschiebt. Die Folie ihrerseits muss relativ zum entstehenden Kunststoffobjekt eine genau vorbestimmte Lage einnehmen, damit das Elektronikbauteil im fertigen Kunststoffobjekt die erforderliche Lage einnimmt. Zur Fixierung des Elektronikbauteils werden verschiedene Methoden angewandt, beispielsweise kann das Elektronikbauteil auf der Folie festgeklebt werden. Die ursprünglich angewandten Methoden erfordern jedoch alle zusätzliche Verfahrensschritte und/oder die Verwendung zusätzlicher Werkstoffe.

Um diese Nachteile zu vermeiden, wurde eine verbesserte Methode entwickelt, die aus der **EP-A-0 599 194** bekannt ist. Bei dieser Methode wird das Elektronikmodul nicht an der Folie fixiert, sondern es erfolgt lediglich eine Positionierung von Folie und Elektronikmodul in einem Formhohlraum, in welchen anschliessend die Kunststoffmasse eingespritzt bzw. eingepresst wird; die definitive Fixierung des Elektronikmoduls erfolgt also erst bei der Einbettung in die zur Bildung des Kunststoffobjektes bestimmten Kunststoffmasse. Die Folie wird in den Formhohlraum eingelegt, und das Elektronikmodul wird lose im Formhohlraum an diese Folie angelegt, so dass in der fertigen Chipkarte die eine Flachseite des Elektronikmoduls an der dem Chipkartenäusseren zugewandten Seite der Folie anliegt, während die gegenüberliegende Flachseite des Elektronikmoduls und seine Seitenflächen von Kunststoffmasse umgeben sind. Während des Spritz- bzw. Pressvorganges müssen die Folie und das Elektronikmodul, wie schön erwähnt, innerhalb des Formhohlraums positioniert werden. Zu diesem Zwecke weist die Form, welche den Formhohlraum bildet, Positionierstifte auf, auf welche das Elektronikmodul und die Folie gewissermassen aufgespiesst werden. Die Fixierung des Elektronikmoduls an der Folie erfolgt dann durch Einspritzen bzw. Einpressen der Kunststoffmasse in den Formhohlraum. Der Positionierungsbereich der Struktur des Elektronikmoduls, an welchen dieselbe aufgespiesst wird, kann die übliche Wandstärke der Struktur aufweisen oder eine verminderte Wandstarke aufweisen und damit eine Einbuchtung bilden oder als Durchbruch durch die Struktur bzw. als Wegbruch eines Randbereichs der Struktur ausgebildet sein Die fur das Aufspiessen der Folie notwendige Deformation bzw. Perforation der Folie wird im allgemeinen durch den Positionierstift selbst erzeugt. Nach dem Einspritzen bzw. Einpressen der Kunststoffmasse wird die Chipkarte ausgeformt. Natürlich gelangt beim Spitz- bzw. Giessvorgang keine Kunststoffmasse an diejenigen Stellen, an welchen sich die Positionierstifte befinden. Diese Stellen bilden demzufolge in der fertigen Chipkarte Einbuchtungen oder durchgehende Löcher, welche sich über die gesamte Höhe der Chipkarte erstrecken können.

Die Anforderungen an elektrisch leitende Verbindungen der eingangs genannten Art sind vielfältig. Sie müssen in jedem Fall einwandfrei funktionieren und über eine gewisse Dauer mechanisch haltbar sein. Dabei ist zu berücksichtigen, dass die Kunststoffobjekte, in welchen diese Verbindungen angeordnet sind, einerseits hohen mechanischen und thermischen Beanspruchungen ausgesetzt sein können und anderseits, da die Elektronikbauteile im allgemeinen endgültig in die Kunststoffmasse eingebettet werden, durch eine nicht mehr funktionierende Verbindung sofort vollständig und irreparabel entwertet sind. Ferner ist zu beachten, dass die meisten Kunststoffobjekte, in denen die Verbindungen vorkommen, Massenprodukte sind, so dass selbst geringfügige Rationalisierungsmassen bei deren Herstellung lohnend sind.

Ein weiteres Problem besteht in den sehr kleinen Abmessungen der Elektronikbauteile und, mindestens bei Chipkarten, der sehr geringen zur Verfügung stehenden Bauhöhe. Schliesslich ist zu beachten, dass die Leiterbahnen mechanisch schwache Gebilde sind; bei der Kontaktierung stellt sich daher das Problem, dass mit Sicherheit eine haltbare elektrische Verbindung erzeugt werden muss, während gleichzeitig die Leiterbahnen entsprechend ihrer mechanischen Empfindlichkeit zu behandeln sind.

Es ist bekannt, eine Leiterbahn zusammen mit einer Folie zu verwenden. An dieser Folie wird als Elektronikbauteil ein Elektronikmodul fixiert, indem die Folie, die Leiterbahn und die Struktur des Elektronikmoduls zu einer Kontaktfolie verbunden werden, dadurch. dass man sie so deformiert, dass innerhalb eines als Kontaktierbereichs bezeichneten Bereichs von Folie, Leiterbahn und Struktur die Leiterbahn mit einer Kontaktstrecke einen leitenden Teil des Elektronikmoduls. im allgemeinen seine Struktur, berührt.

Bei einem bekannten Verfahren zur Herstellung einer elektrischen Verbindung zwischen einer Leiterbann und einer metallischen Struktur eines Elektronikmoduls wird in einem ersten Verfahrensschritt diese Struktur mittels eines sich quer zur Struktur bewegten Werkzeuges deformiert und durchbrochen, derart, dass ein kronenartig deformierter Bereich der Struktur entsteht, der in der fertigen Kontaktfolie in den Kontaktierbereich zu liegen kommt. Dieser kronenartige Bereich der Struktur wird dann in einem zweiten Verfahrensschritt gewissermassen als Werkzeug verwendet, um die Folie mit der Leiterbahn so zu deformieren, dass die Leiterbahn mit einer Kontaktstrecke an der Struktur anliegt. Dadurch erreicht man gleichzeitig, dass Folie, Leiterbahn und Struktur im Kontaktierungsbereich aneinander fixiert sind und in einem weiteren Schritt gemeinsam in Kuriststoffmasse eingebettet werden können, wozu sich. verschiedene Verfahren wie beispielsweise Giessen, Spritzen, Pressen, Spritzprägen oder Laminieren anbieten.

Dieses vorbekannte Verfahren weist mehrere Nachteile auf, die darauf beruhen, dass als gewissermassen internes Werkzeug zur Herstellung der elektrisch leitenden Verbindung der kronenartig deformierte Bereich der Struktur des Elektronikmoduls eingesetzt wird. Dadurch wird einerseits bedingt, dass die Struktur mindestens bereichsweise metallisch ist; Elektronikmodule, deren Struktur nichtmetallisch ist, lassen sich also nicht auf diese Weise mit einer Leiterbahn kontaktieren. Anderseits muss die Struktur verhältnismässig massiv sein; dies steht im Widerspruch zum allgemeinen Wunsch, Elektronikmodule mit möglichst dünnen und leichten Strukturen zu verwenden. Schliesslich bringt es die kronenartige Deformation mit sich, dass die Struktur und somit auch die Folie im Kontaktierbereich perforiert, genauer geschlitzt, ist, was insbesondere unerwünscht ist, wenn die Folie dazu bestimmt ist, im.fertigen Kunststoffobjekt eine Aussenfläche zu bilden. Die Erzeugung von einwandfreien Oberflächen bei Verwendung dünner Folien ist nur mit aufwendigen Massnahmen möglich, weil die durch die Deformation der Folie in der letzteren entstehenden Schlitze endgültig mit metallischem Material der kronenartigen Deformation der Struktur gefüllt sind und bei der Einbettung der Kontaktfolie in die Kunststoffmasse nicht so behandelt werden können, dass sie mindestens annähernd unsichtbar werden.

Der Erfindung liegt die Aufgabe zugrunde ein Verfahren zur Herstellung eines Kunststoffobjektes der eingangs genannten Art anzugeben, bei welchem das Elektronikbauteil in einfacher Weise und ohne zusätzliche Werkstoffe an der Folie fixiert werden kann ohne dass diese Fixierung Einbuchtungen oder Locher im fertigen Kunststoffobjekt zur Folge hat. Eine weitere Aufgabe wird darin gesehen das Elektronikbauteil bei der Fixierung bei Bedarf in elektrisch leitenden Kontakt mit einer Leiterbahn zu bringen.

Die Aufgabe wird durch die Merkmale des Patentanspruches 1 gelöst. Vorteilhafte Weiterbildungen des erfindungsgemässen Verfahrens werden durch die vom Patentanspruch 1 abhängigen Patentansprüche definiert.
Während beim vorbekannten Verfahren gemäss der **EP-A-0 599 194** die Positionierung des Elektronikmoduls an der Folie im Formhohlraum durch die Positionierstifte und die eigentliche Fixierung erst bei der Einbettung von Folie und Elektronikmodul in die Kunststoffmasse erfolgt, wird erfindungsgemäss das Elektronikbauteil durch eine Deformation der Folie an der Folie fixiert; bei der Weiterverarbeitung, beispielsweise in einem Formhohlraum, oder während eines Laminiervorganges, muss anschliessend nur die Folie selbst positioniert werden, da die Positionierung des Elektronikmoduls mittelbar über seine Fixierung an der Folie erfolgt. Es sei nur kurz erwähnt, dass die Positionierung der Folie beispielsweise entlang ihres Randbereiches erfolgen kann und jedenfalls so durchführbar ist, dass sie keine Einbuchtungen oder Löcher im fertigen Kunststoffobjekt hinterlässt.

Neben der angestrebten einwandfreien Fixierung des Elektronikbauteils an der Folie ohne die Verwendung zusätzlicher Werkstoffe wie beispielsweise Kleber und unter Vermeidung von Löchern im fertigen Kunststoffobjekt ist es ein wesentlicher Vorteile des erfindungsgemässen Verfahrens, dass auf der dem äusseren zugewandten Fläche der Folie kein optisch störender Eindruck entsteht und dass grundsätzlich die Herstellung der Kunststoffobjekte nach dem neuen Verfahren auf bereits vorhandenen Anlagen durchgeführt werden kann.

Wie schon die Positionierung des Elektronikbauteils beim herkömmlichen Verfahren, kann auch seine Fixierung beim neuen Verfahren an einer Stelle der Struktur des Elektronikbauteils erfolgen, an welcher diese Struktur ihre unveränderte Wandstärke aufweist. In diesem Falle wird die Deformation der Folie, welche die Fixierung verursacht, im allgemeinen eine Perforation sein.

Vorzugsweise erfolgt aber die Fixierung des Elektronikbauteits an einer Stelle der Struktur des Elektronikbauteils. die eine reduzierte Wandstärke in Form einer im allgemeinen der Folie zugewandten Einbuchtung oder Delle besitzt. Die Folie wird in diesem Fall gedehnt sowie ausgebogen und ggfs. auch perforiert

Besonders vorteilhaft ist es, als Fixierungsbereich den Bereich eines Durchbruchs oder eines randständigen Wegbruchs der Struktur vorzusehen. In diesen Fällen wird die Deformation der Folie in einer Dehnung und Ausbiegung und in einer Perforation des Folienmaterials bestehen.

Im allgemeinen ist vorgesehen, bei der Herstellung von Kunststoffobjekten durch Giessen, Pressen oder Spritzen das Elektronikbauteil an der Folie zu fixieren, solange es sich ausserhalb des Formhohlraums befindet. Dabei entsteht eine mit dem Elektronikbauteil bestückte Folie, die dann in den Formhohlraum eingebracht wird. Die Fixierung des Elektronikbauteils an der Folie kann aber auch innerhalb des Formhohlraums stattfinden, beispielsweise unter Benutzung eines zylindrischen Stiftes mit flacher Front.

Im Fixierungsbereich kann mindestens ein weiteres konstruktives Element, insbesondere eine Leiterbahn, des herzustellenden Kunststoffobjektes angeordnet sein, die zusammen mit der Folie deformiert wird, um mit der Folie und dem Elektronikbauteil eine Verbundfolie oder Kontaktfolie zu bilden.

Dabei erfolgt die Herstellung der elektrischen Verbindung dadurch, dass das Elektronikbauteil mit nicht deformierter Struktur auf die Folie mit der in, an oder auf ihr angeordneten Leiterbahn gebracht wird und dass anschliessend im Kontaktierbereich eine Deformation der Folie durch ein externes Werkzeug durchgeführt wird. Es sei darauf hingewiesen, dass Folie, Leiterbahn und Elektronikbauteil bzw. Struktur sich in beliebiger Reihenfolge folgen können. Durch die Verwendung einer externen Werkzeugeinrichtung wird es beispielsweise möglich, nicht nur Elektronikbauteile mit metallischen Strukturen sondern auch Elektronikbauteile mit nichtmetallischen Strukturen die lediglich einen metallisierten und dadurch leitenden Kantenbereich besitzen, zu bearbeiten. Da nicht ein kronenartig deformierter Bereich der Struktur als Werkzeug für die Deformation von Folie und Leiterbahn benutzt wird, sondern, wie erwähnt, eine externe Werkzeugeinrichtung verwendet wird. wird es auch möglich, eine verhältnismässig dünne Struktur vorzusehen, was der allgemeinen Entwicklungstendenz im Bereich der Elektronikmodule bzw. der Kontaktfolien und teilweise der Elektronikmodule enthaltenden Kunststoffobjekte entspricht. Die Herstellung der elektrisch leitenden Verbindung wird rationalisiert da die Anzahl der Verfahrensschritte sich um einen reduziert indem sich die Erzeugung der krononartigen Deformation der Struktur erübrigt

Das Wegfallen der kronenartigen Deformation der Struktur und der dadurch bedingten schlitzartigen Perforation der Folie erlauben zudem die Erzeugung von Kontaktfolien mit einwandfreien Oberflächen, was besonders für dünne Kontaktfolien, die zur Einbettung in Kunststoffobjekte bestimmt sind, bei welchen sie eine Aussenfläche bilden, einen wesentlichen Vorteil darstellt. Ein zusätzlicher Vorteil des neuen Verfahrens liegt schliesslich darin, dass gleichzeitig mit der Herstellung der elektrisch leitenden Verbindung und gleichenorts, also ebenfalls im Kontaktierbereich, eine solide gegenseitige form- und/oder kraftschlüssige mechanische Fixierung von Folie, Leiterbahn und Struktur realisiert werden kann.

Die Leiterbahn kann, wie schon erwähnt, vor der Deformation lediglich an der Folie anliegen oder ganz oder teilweise mit dieser verbunden sein, beispielsweise durch ein Kleb-, Ätz-, Druck-, Aufdampf- oder Prägeverfahren.

Bevorzugt werden Leiterbahnen in Leiterbahnstrukturen verwendet, beispielsweise in Form von FPC (Flexible Printed Circuits); die Folien der FPC können zusätzlich oder anstelle der Folie verwendet werden.

In gewissen Fällen können auch FPC verwendet werden, welche mindestens zwei leitende Schichten enthalten, wobei benachbarte leitende Schichten jeweils durch eine Isolationsschicht getrennt sind. Bei der Kontaktierung werden dann nicht nur die leitenden Schichten bzw. Leiterbahnen mit der Struktur verbunden, sondern es werden auch die leitenden Schichten unter sich miteinander kontaktiert.

Es wird als wesentlicher Vorteil der Erfindung betrachtet, dass Elektronikmodule mit nichtmetallischer Struktur verwendet werden können, insofern sie nur im Kontaktierbereich einen elektrisch leitenden bzw. metallisierten Kantenbereich besitzen. Selbstverständlich können auch Elektronikmodule mit metallischer Struktur zur Herstellung der neuen Kontaktfolie benutzt werden.

Der leitende Kantenbereich der Struktur, an welchem in der fertigen Kontaktfolie die Leiterbahn mit einer Kontaktstrecke anliegt, kann entweder ein Randbereich eines Durchbruchs oder ein mit der Strukturberandung verbundener Randbereich eines Wegbruchs der Struktur sein

Vorzugsweise wird eine Leiterbahn verwendet, die mindestens im Kontaktbereich blank ist, so dass der sonst notwendige Vorgang der Abisolierung der Leiterbahn entfällt.

Es lässt sich aber auch eine isolierte Leiterbahn verwenden, welche dann allerdings vor oder bei der Herstellung der elektrisch leitenden Verbindung mindestens im Kontaktierbereich abisoliert werden muss; dazu eignen sich mechanische, chemische oder thermische Verfahren.

Eine mehrfache und damit verbesserte Kontaktierung erhält man, indem man den im Kontaktierbereich liegenden bzw. auszubiegenden Teil der Leiterbahn in der ursprünglichen Leiterbahnebene so biegt, dass er den leitenden Kantenbereich, der sich im übrigen nicht auf einer Geraden befinden muss, mindestens ein oder mehrere zusätzliche Male kreuzt, so dass er nach der Deformation mit einer bzw. mehreren zusätzlichen Kontaktstrecken am leitenden Randbereich anliegt und so eine bzw. mehrere zusätzliche elektrisch leitende Verbindungen ergibt. Ein grosser Vorteil einer in ihrer Ebene gebogenen Leiterbahn ist auch darin zu sehen, dass durch die Biegungen gewissermassen eine Reserve an Leiterbahnlänge erzeugt wird, so dass das Brechen bzw. Reissen der Leiterbahn bei der Ausbiegung, auch wenn sie dabei festgeklemmt wird, verhindert werden kann.

Die Vorrichtung, mittels welcher das Elektronikbauteil an der Folie fixiert wird, ist sehr einfach und lässt sich, wie weiter oben erwähnt, problemlos auf üblichen Anlagen zur Herstellung von Kunststoffobjekten implementieren. Die Vorrichtung weist im wesentlichen eine Aufnahmeeinrichtung auf, welche zur Aufnahme der Folie vorgesehen ist. Die Aufnahmeeinrichtung besitzt eine Ausnehmung, durch welche sich eine Werkzeug-einrichtung in Form eines Stempels quer zur Aufnahmeeinrichtung hin- und herbewegen und sich ggfs. auch drehen kann. Das Elektronikbauteil und ggfs. ein oder mehrere weitere konstruktive Elemente des herzustellenden Kunststoffobjektes, insbesondere ein FPC werden so auf der Folie angeordnet und niedergehalten, dass sich der Fixierungsbereich der Struktur des Elektronikbauteils oberhalb der Ausnehmung der Auflagefläche befindet. Die Struktur des Elektronikbauteils kann metallisch oder nichtmetallisch und verhältnismässig dünn sein. Der Stempel wird aus einer Ausgangslage, in welcher seine Stempelfront von Folie und Struktur beabstandet ist. in eine Endlage gebracht. in welcher er mit der Stempelfront die Folie und ggfs. die Struktur des Elektronikbauteils sowie, falls vorhanden. das weitere konstruktive Element des Kunststoffobjektes deformiert, anschliessend ragt Folienmaterial in eine Delle bzw. in oder durch den Durch- oder Wegbruch der Struktur des Elektronikbauteils, derart, dass sich eine Fixierung des Elektronikbauteils an der Folie ergibt.

Mindestens annähernd fluchtend mit dem Stempel kann ein weiterer Stempel angeordnet sein, der als Gegenstempel wirkt. Mit dem Gegenstempel erzielt man eine Verbesserung der Fixierung, da die ohne Gegenstempel ausgebogenen Teile durch den Gegenstempel weiter gebogen werden. Im weiteren kann der Gegenstempel zu einer Qualitätssteigerung des Fixierungsbereichs im Sinne einer Verbesserung der ihm zugewandten Fläche der Verbundfolie verhelfen.

Der Gegenstempel kann ortsfest ausgebildet sein, so dass der Abstand zwischen seiner Stempelfront und der Aufnahme für die Folie konstant ist. In diesem Falle ist es im allgemeinen erforderlich, dass durch Ausnehmungen an der Stempelfront und/oder an der der Stempelfront zugewandten Seite der Struktur des Elektronikbauteils Raum für das Folienmaterial der deformierten Folie vorgesehen wird.

Der Gegenstempel kann auch linear beweglich sein, indem er federnd abgestützt und/oder mit einem entsprechenden Antrieb versehen ist. Schliesslich kann auch der Gegenstempel drehbar sein.

Der Querschnitt des länglichen Stempelteils sowohl des Stempel wie auch des Gegenstempels kann beliebig sein, jedoch werden Querschnitte in Form eines Polygons oder Kreises bevorzugt. In gewissen Fällen empfiehlt es sich auch, den länglichen Stempelteil schraubenähnlich auszubilden.

Die Stempelfront sowohl des Stempels wie auch des Gegenstempels kann eben sein, wobei man einen Stempel mit einer ebenen Stempelfront vorzugsweise dann verwendet. wenn die Folie bei ihrer Deformation nicht durchstossen werden soll.

Beabsichtigt man eine Durchstossung der Folie, so benutzt man vorzugsweise einen Stempel bzw. Gegenstempel mit einer Stempelfront in Form einer Pyramide oder eines Kegels bzw. einer Spirale.

In gewissen Fällen kann es sich als vorteilhaft erweisen, in den Fixierungsbereich Energie einzukoppeln. Die Deformation der Folie besteht dann auch oder ausschliesslich in einem Aufweichen oder sogar Schmelzen des entsprechenden Folienbereiches. Zum Zweck der Beheizung des Fixierungsbereiches können der Stempel und/oder der Gegenstempel bzw. das Elektronikbauteil bzw. die Aufnahme der Folie beheizbar ausgebildet sein, wobei im allgemeinen Temperaturen in Frage kommen, die keinen wesentlichen Einfluss auf die Festigkeit und das Verhalten metallischer Bestandteile des Elektronikbauteils und ggfs. des weiteren konstruktiven Elementes haben. Die Beheizung kann auch mit Reibungswärme erfolgen, die bei der Bewegung der Stempel generiert wird. Durch eine Erwärmung des Kontaktierbereichs kann gleichzeitig die weiter oben erwähnte Abisolierung der Leiterbahn erfolgen.

Die nach dem neuen Verfahren hergestellte Kontaktfolie bildet ein Zwischenprodukt bei der Herstellung von Kunststoffgegenständen, welche Elektronikbauteile enthalten. Sie umfasst, wie bereits mehrfach erwähnt, die eigentliche Folie, eine oder mehrere Antennen und ein oder mehrere auf einer oder mehreren Strukturen aufgebaute Elektronikbauteile. Dank des herstellungsmässigen und örtlichen Zusammenfallens der Fixierung von Folie, Leiterbahn und Struktur mit der Kontaktierung von Leiterbahn und leitendem Kantenbereich der Struktur erhält man eine sowohl mechanisch wie elektrisch haltbare und zuverlässige Verbindung.

Die neue Kontaktfolie wird verwendet zur Herstellung von Kunststoffobjekten, welche Elektronikbauteile enthalten. Sie eignet sich einerseits, infolge ihrer einwandfreien und verhältnismässig unempfindlichen elektrischen Kontaktierung, für verhältnismässig anspruchsvolle Kunststoffobjekte wie beispielsweise Tags, Spielzeuge und mobile Kommunikationsgeräte; anderseits lasst sie sich problemlos auch in einfachen Kunststoffobjekten wie beispielsweise Chipkarten verwenden. Ihre Verwendung drängt sich insbesondere dann auf. wenn Kunststoffobjekte hergestellt werden, bei welchen eine Aussenfläche durch die Kontaktfolie gebildet wird. da diese es erlaubt, solche Kunststoffobjekte mit einer folienseitig einwandfreien Aussenfläche herzustellen.

Im folgenden wird die Erfindung anhand von Beispielen und mit Bezug auf die Zeichnung, die einen integrierenden Teil der vorliegenden Offenbarung bildet, ausführlich beschrieben
Es zeigen
- **Fig. 1A**: ein erstes Beispiel einer Folie und einer an ihr zu fixierenden Struktur eines Elektronikmoduls, vor der Deformation der Folie; Dieses Beispiel erleichtert das Verständnis der Erfindung.
- **Fig. 1B**: Folie und Trägerstruktur gemäss **Fig. 1A,** jedoch nach der Deformation der Folie;
- **Fig. 2A**: ein zweites Beispiel einer Folie und einer an ihr zu befestigenden Struktur eines Elektronikmoduls, vor der Deformation der Folie; Dieses Beispiel erleichtert das Verständnis der Erfindung.
- **Fig. 2B**: Folie und Trägerstruktur gemäss **Fig. 2A,** jedoch nach der Deformation der Folie;
- **Fig. 3A**: ein drittes Beispiel einer Folie und einer an ihr zu befestigenden Struktur eines Elektronikmoduls, vor der Deformation der Folie; Dieses Beispiel erleichtert das Verständnis der Erfindung.
- **Fig. 3B**: Folie und Trägerstruktur gemass **Fig. 3A,** jedoch nach der Deformation der Folie durch Dehnung und Ausbiegung;
- **Fig. 3C**: ist ein Ausführungsbeispiel der Erfindung gemäß dem Anspruch 1 und stellt eine Folie und Trägerstruktur gemäss **Fig. 3A** dar, jedoch nach der Deformation. der Folie durch Dehnung. und Ausbiegung und Perforation;
- **Fig. 4**: das Prinzip des erfindungsgemässen Verfahrens am Beispiel eines Kontaktierbereiches einer Kontaktfolie in axonometrischer Darstellung;
- **Fig. 5**: einen weiteren Kontaktierbereich einer Kontaktfolie, ebenfalls in axonometrischer Darstellung;
- **Fig. 6**: ein Beispiel eines Kontaktierbereiches vor der Deformation in vereinfachter Darstellung, von oben;
- **Fig. 7**: ein erstes Ausführungsbeispiel einer zur Durchführung des erfindungsgemassen Verfahrens geeigneten vorrichtung;
- **Fig. 8**: ein zweites Ausfuhrungsbeispiel der Vorrichtung.
- **Fig. 9**: ein als Chipkarte ausgebildetes Kunststoffobjekt mit einer eingebetteten Folie;
- **Fig. 10A**: ein weiteres Ausführungsbeispiel einer Folie und einer an ihr zu befestigenden Struktur eines Elektronikmoduls, vor der Deformation der Folie;
- **Fig. 10B**: Folie und Trägerstruktur gemäss **Fig. 10A,** jedoch nach der Deformation der Folie durch Weichmachen oder Schmelzen.
- **Fig. 11A**: ein noch weiteres Ausführungsbeispiel einer Folie und einer an ihr zu befestigenden Struktur eines Elektronikmoduls, vor der Deformation der Folie;
- **Fig. 11B**: Folie und Trägerstruktur gemäss **Fig. 11A,** jedoch nach der Deformation der Folie durch Weichmachen oder Schmelzen;
- **Fig. 12**: einen Kontaktbereich mit einer besonderen Leiterbahn;
- **Fig. 13A**: einen Kunststoffgegenstand, in welchem eine bei der Kontaktierung nicht perforierte Kontaktfolie eingebettet ist; und
- **Fig. 13B**: einen Kunststoffgegenstand, in welche eine bei der Kontaktierung perforierte Folie eingebettet ist.

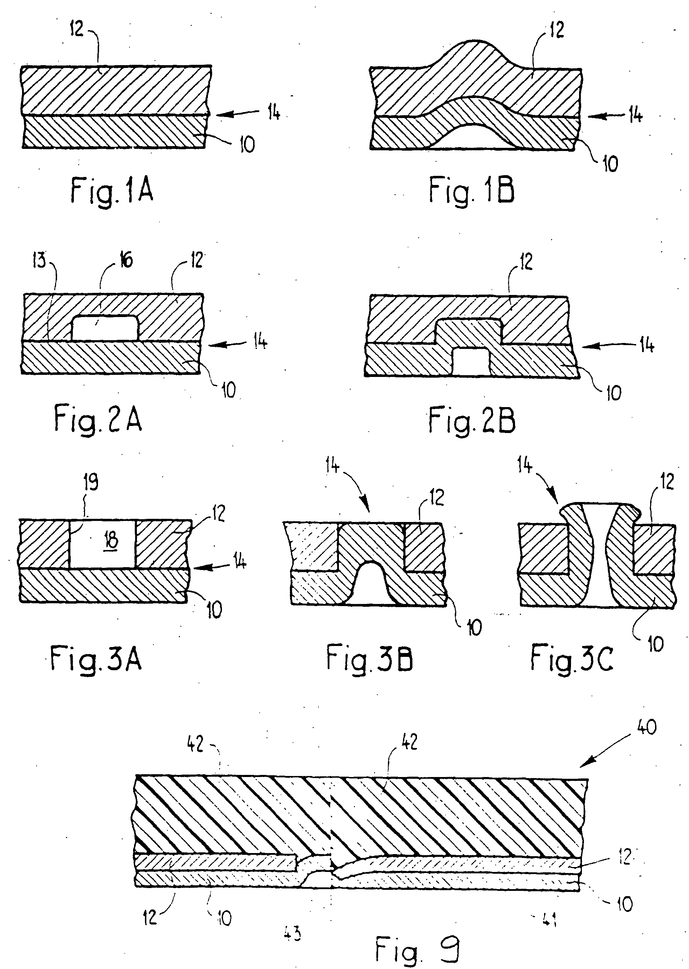

Die **Fig. 1A** zeigt eine Folie **10** und eine an ihr mechanisch zu fixierende Struktur **12** eines nicht weiter dargestellten Elektronikmoduls, wobei sich die Figur auf den eigentliche Fixierungsbereich **14** beschränkt. Die Struktur **12** ist durchgehend, also ohne dellenartige Ausnehmung, Durch- oder Wegbruch ausgebildet; sie kann aus einem metallischen oder nichtmetallischen Material hergestellt sein und eine verhältnismässig geringe Wandstärke aufweisen. Die Folie **10** ist aus einem nicht leitenden Material, im allgemeinen aus Kunststoff, hergestellt.

Die **Fig. 1B** zeigt wiederum den Fixierungsbereich **14** mit der Folie **10** und der Struktur **12**. jedoch nach der Fixierung der Struktur **12** an der Folie **10** Bei der Deformation, durch welche die Fixierung der Struktur **12** an der Folie **10** zustande kommt, wird bei diesem Ausführungsbeispiel nicht nur die Folie **10** durch Dehnung und Ausbiegung deformiert, sondern auch die Struktur **12,** was darauf zurückzuführen ist, dass die Struktur **12** vor der Fixierung weder eine dellenartige Ausnehmung noch einen Durchbruch oder Wegbruch aufgewiesen hat. Bei einer Anordnung gemäss **Fig. 1A** könnten ggfs. die Folie **10** und/oder die Struktur **12** nicht nur gedehnt und ausgebogen, sondern auch perforiert werden.

In der **Fig. 2A** ist ein weiterer Fixierungsbereich **14** mit einer Folie **10** und einer an dieser zu fixierenden Struktur **12** dargestellt. Die Struktur **12** besitzt an ihrer der Folie **10** zugewandten Fläche **13** eine dellenartige Ausnehmung **16.**

Bei der Deformation der Folie **10** wird diese gemäss der **Fig. 2B** im Fixierungsbereich **10** gedehnt und ausgebogen und dabei örtlich in die Ausnehmung **16** hineingepresst. Die Struktur **12** wird beim vorliegenden Beispiel praktisch nicht deformiert. Je nach Dimensionierung, verwendeten Materialien, Formen des Stempels und herrschender Temperatur können aber auch bei Strukturen mit Ausnehmungen Strukturdeformationen eintreten.

Die **Fig. 3A** zeigt einen dritten Fixierungsbereich **14,** ebenfalls mit einer Folie **10** und einer Struktur **12.** Die Struktur **12** weist bei diesem Beispiel einen Durchbruch **18,** der von einer Wandung **19** begrenzt ist, auf.

In der **Fig. 3B** ist der Fixierungsbereich **14** der **Fig. 3A** nach der Fixierung dargestellt. Bei der Fixierung wurde die Folie **10** gedehnt und ausgebogen, so dass sie in die Ausnehmung **18** hineinragt, wobei sie ggfs. auch durch die Ausnehmung **18** hindurchragen könnte. Die Struktur **12** ist durch die Fixierung praktisch nicht deformiert, doch könnte, wie mit Bezug auf **Fig. 2B** beschrieben, auch bei diesem Ausführungsbeispiel eine Deformation der Struktur erfolgen.

Die **Fig. 3C** zeigt denselben Fixierungsbereich **14** wie die **Fig. 3A.** jedoch nach der Fixierung. Die Fixierung erfolgte hierbei durch Dehnung. Ausbiegung und Perforation der Folie **10.** während die Struktur im wesentlichen undeformiert ist. Wie mit bezug auf **Fig. 2B** beschrieben, könnte mit der Deformation der Folie **10** auch eine Deformation cer Struktur **12** einhergehen.

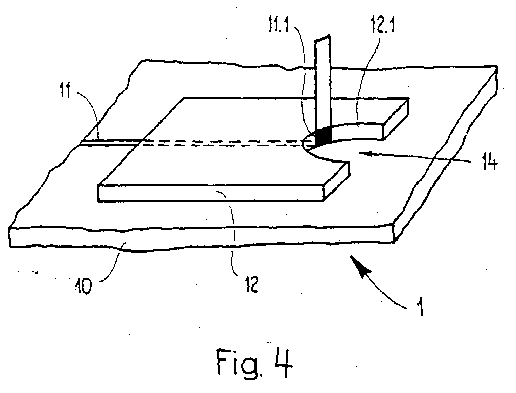

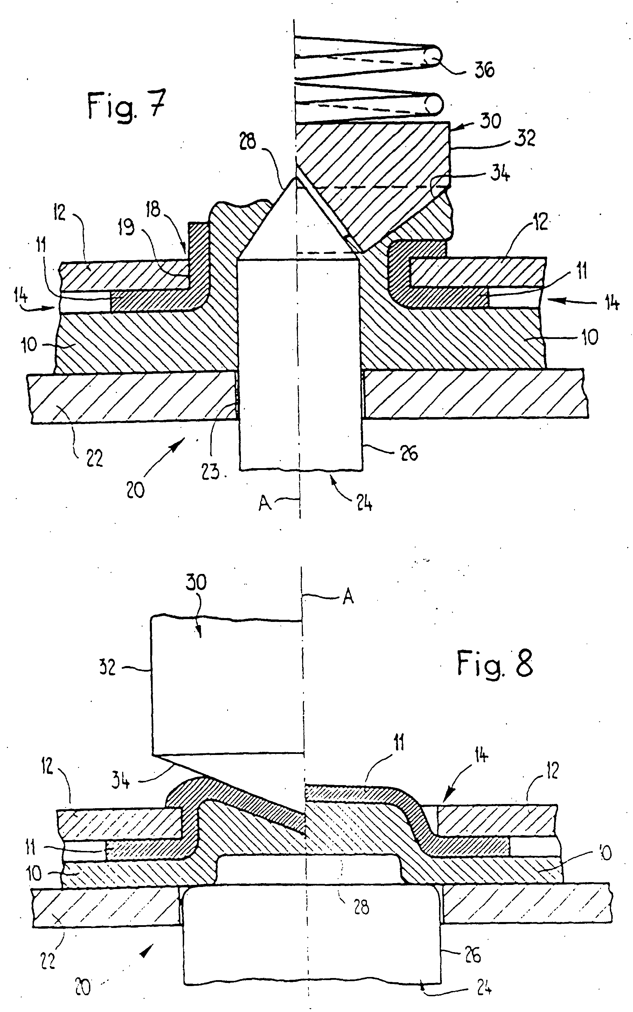

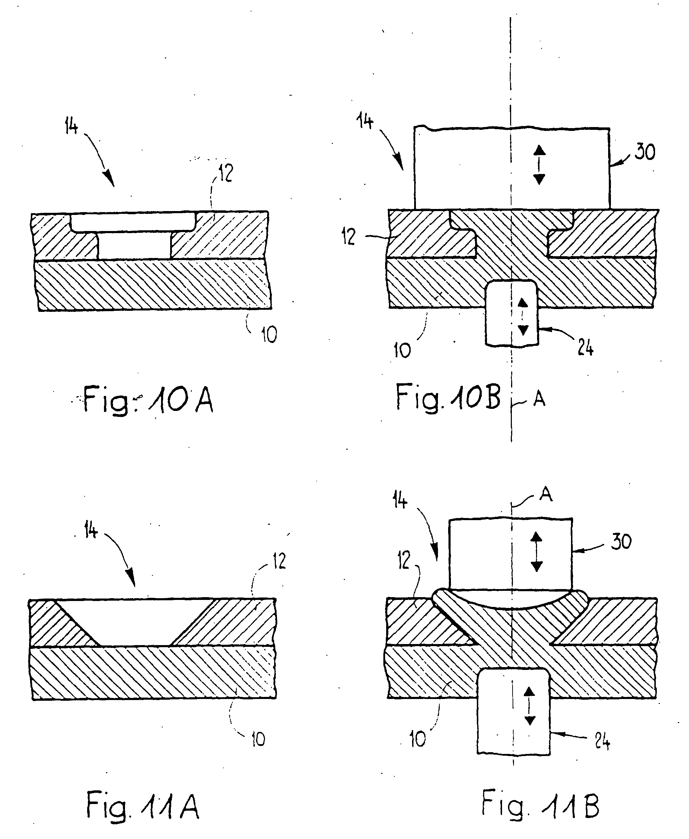

In der **Fig. 4** ist ausschnittweise eine Kontaktfolie **1,** umfassend eine Folie **10,** eine als Antenne **11** vorgesehene Leiterbahn und als Elektronikbauteil ein Elektronikmodul mit einer Struktur **12** in einem Kontaktierbereich **14** dargestellt. Die Struktur **12** besitzt einen von der Strukturberandung ausgehenden Wegbruch mit einem leitenden Kantenbereich **12.1;** es sei hier angemerkt, dass der leitende Kantenbereich auch eine Begrenzung eines allseitig berandeten Durchbruches sein könnte. Zur Verdeutlichung der Darstellung ist lediglich die Leiterbahn **11** in ihrer deformierten Konfiguration, in welcher sie mit einer Kontaktstrecke **11.1** am leitenden Kantenbereich **12.1** anliegt, während die in Wirklichkeit ebenfalls deformierte Folie **10** in ihrer nichtdeformierten Konfiguration abgebildet ist. In Wirklichkeit ist auch die Folie **10** deformiert, und zwar entweder gedehnt und nach oben ausgebogen oder gedehnt, ausgebogen und zusätzlich perforiert, wie dies weiter unten mit Bezug auf die **Fig. 7** und **8** beschrieben wird.

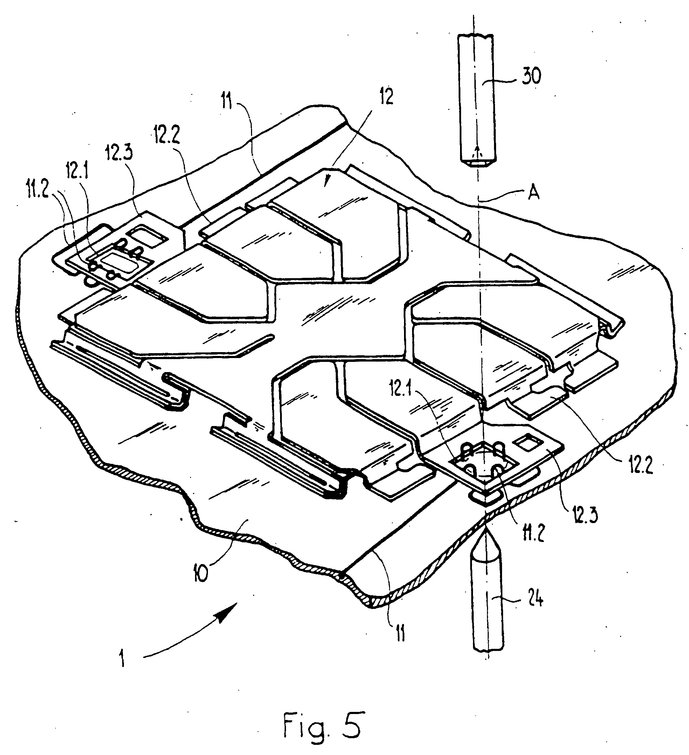

Die **Fig. 5** zeigt ausschnittweise eine weitere Kontaktfolie **1,** umfassend eine Folie **10,** eine längliche, in ihrer Ebene gebogene Leiterbahn **11,** von welcher die beiden an einander gegenüberliegenden Seiten **12.2** der Struktur **12** des Elektronikmoduls angeordneten Leiterbahnenden **11.2** sichtbar sind, sowie die Struktur **12.** Die Struktur **12** besitzt an jeder der erwähnten, einander gegenüberliegenden Seiten. **12.2** einen Ansatz **12.3** mit einem Durchbruch, wobei diese Durchbrüche von elektrisch leitenden Kantenbereichen **12.1** begrenzt sind. Obwohl die dargestellten Durchbrüche quadratisch sind, lässt sich das erfindungsgemässe Verfahren auch durchführen, wenn die Durchbrüche anders geformte Konturen, beispielsweise Rechtecke, Polygone oder Kreise, aufweisen. Es sei auch darauf hingewiesen, dass die leitenden Kantenbereiche nicht genau senkrecht zur Folie verlaufen müssen.

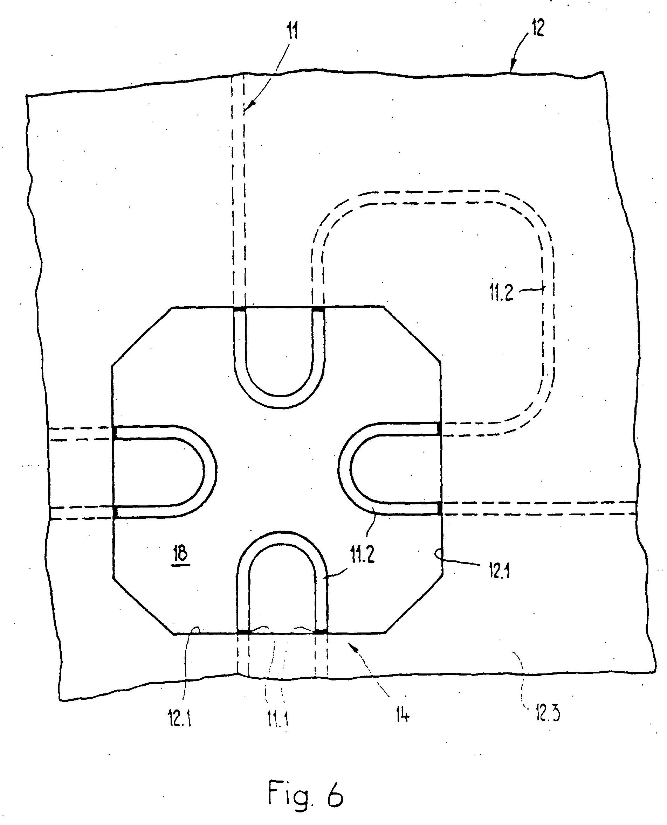

Die Leiterbahnenden **12.2** sind vor ihrer Deformation gemäss **Fig. 6** in ihrer zur Folie **10** parallelen Ebene vielfach wellen- und maanderähnlich gebogen und so angeordnet, dass sie die leitenden Kantenbereichen mehrmals kreuzen. Nach der Deformation sind sie gemäss **Fig. 5** auch senkrecht um mindestens annähernd 90° bzw. parallel zu den leitenden Kantenbereichen **12.1** ausgebogen: dies hat zur Folge, dass an jeder der ursprünglichen Kreuzungsstellen der Leiterbahnenden **11.2** mit den leitenden Kantenbereichen **12.1** eine elektrische leitende Verbindung entsteht, indem die Leiterbahnenden **11.2** mit einer Kontaktstrecke pro ursprunglicher Kreuzung an den leitenden Kantenbereichen **12.1** anliegen In der **Fig 6** sind die zur Bildung der Kontaktstrecken **11.1** vorgesehenen Teile der Leiterbahnenden **11.2** schwarz dargestellt, obwohl sie sich in ihrem Aufbau natürlich nicht vom Rest der Antennenenden **11.2** unterscheiden. Die Länge bzw. Höhe der Kontaktstrecken **11.1** ist im Prinzip durch die Wandstärke der Struktur **12** im Kontaktierbereich **14** bzw. durch die Höhe der leitenden Kantenbereiche **12.1** bestimmt.

In der **Fig. 7** ist ein erstes Ausführungsbeispiel einer Vorrichtung **20** zur Herstellung einer Kontaktfolie **1** dargestellt, wobei im selben Kontaktierbereich **14** simultan die Folie **10** und die Antenne **11** deformiert und die elektrisch leitende Verbindung zwischen der Antenne **11** und der Struktur **12** hergestellt wird. Ggfs. kann damit auch eine Deformation der Struktur **12** einhergehen. Gemäss der **Fig. 7** ist die Antenne **11** zwischen der Folie **10** und der Struktur **12** angeordnet; diese Anordnung ist aber nicht zwingend, vielmehr können die Folie **10,** die Antenne **11** und die Struktur **12** auch in anderen Reihenfolgen angeordnet werden.

Die Vorrichtung **20** besitzt eine plattenförmige Aufnahmeeinrichtung **22.** auf welcher die Folie **10** mit der Antenne **11** und der Struktur **12,** die auf der Folie **10** liegen, aufgenommen ist. Im weiteren besitzt die Vorrichtung **20** eine Werkzeugeinrichtung in Form eines Stempels **24,** der mittels eines nicht dargestellten Antriebs in einer Ausnehmung **23** der Aufnahmeeinrichtung **22** senkrecht bzw. in Richtung der Achse **A** hin- und herbewegbar und in gewissen Ausführungen der Vorrichtung **20** um die Achse **A** drehbar sein kann. Der Stempel **24** weist einen zylindrischen Stempelteil **26** und eine konisch zulaufende Stempelfront **28** auf. Fluchtend mit dem Stempel **24** angeordnet und bewegbar ist ein weiterer Stempel **30** mit einem länglichen Stempelteil **32** und einer Stempelfront **34** angeordnet, welcher nur in der rechten Hälfte der **Fig. 7** sichtbar ist und als Gegenstempel benutzt wird. Der Stempelteil **32** und die Stempelfront **34** des zweiten Stempels **30** können in verschiedensten Weisen ausgebildet sein, insbesondere kann die Stempelfront **34** komplementär zur Stempelfront **28** ausgebildet sein. Der Stempel **30** ist, wie schematisch durch die Feder **36** angedeutet. nachgiebig abgestützt. Der Stempel **24** und der Gegenstempel **30** welche langs der Achse **A** linear verschiebbar sind und um die Achse **A** drehbar sein können. sind im übrigen aucn aus **Fig. 5** ersichtlich.

Die **Fig. 7** zeigt in ihrer linken Hälfte die Deformation der Folie **10** und der Leiterbahn **12** wie sie unter der Wirkung des Stempels **24,** jedoch vor der Wirkung des Gegenstempels **30** zustande kommt. Während sich die Struktur **12** praktisch nicht deformiert, wird die Antenne **11** aus ihrer ursprünglichen Lage um 90° nach oben durch den von der Wandung **19** begrenzten Durchbruch **18** der Struktur **12** ausgebogen. Gleichzeitig wird die Folie **10** gedehnt und ebenfalls nach oben ausgebogen, derart, dass sie durch die Ausnehmung **18** der Struktur **12** ragt, wobei sie durch die Spitze der konisch zulaufenden Stempelfront **28** durchtrennt wird. In ihrer rechten Hälfte zeigt die **Fig. 7** schliesslich die Konfiguration von **Folie 10,** Leiterbahn **11** und Struktur **12** nach der Wirkung des weiteren Stempels **30.** Die Leiterbahn **11** ist um weitere 90° gebogen worden und liegt nur im wesentlichen an der oberen Fläche der Struktur **12** an, während Bereiche der Folie **10** weiter nach oben ragen.

Ein weiteres Ausführungsbeispiel der Vorrichtung **20** ist in der **Fig. 8** dargestellt, welche wie die **Fig. 7** die Fixierung der Leiterbahn **11** und der Struktur **12** an der Folie **10** zeigt, wobei im Kontaktierbereich **14** die Konfiguration von Folie **10,** Leiterbahn **11** und Struktur **12** in der rechten Hälfte von **Fig. 8** nach der Wirkung des Stempels **24** jedoch vor der Wirkung des Stempels **30** und in der linken Hälfte von **Fig. 8** nach der Wirkung des Stempels **30** ersichtlich ist. Die Vorrichtung gemass **Fig. 8** ist im wesentlichen gleich ausgebildet wie die Vorrichtung gemäss **Fig. 7,** und ihre einzelnen Teile sind mit denselben Bezugszeichen versehen wie in **Fig. 7,** auch wenn sie gewisse Einzelheiten aufweisen, die anders geformt sind. Insbesondere sind die Stempelfront **28** des Stempels **24** eben und die Stempelfront **34** des zweiten Stempels **30** zulaufend ausgebildet. Mit dieser Vorrichtung **20** erzielt man eine Fixierung, bei welcher die Folie **10** nur gedehnt und ausgebogen, jedoch nicht perforiert wird.

In der **Fig. 9** ist als Beispiel für ein Kunststoffobjekt **40,** das ein Elektronikmodul enthält, eine Chipkarte im üblichen Kreditkartenformat dargestellt. Durch die Fixierung der Struktur **12** des Elektronikmoduls an der Folie **10** erhält man eine einfach herstellbare und solide gegenseitige Verbindung von Folie **10** und Struktur **12,** so dass sich die Verwendung von Positionierstiften zur Halterung derselben wahrend der Einbettung in eine das Gehause des Kunststoffobjektes bildende Kunststoffmasse **42** erübrigt. Das auf diese Weise hergestellte Kunststoffobjekt **40** weist daher keine Locher auf. Das fertige Kunststoffobjekt **40** kann. wie in der linken Hälfte der **Fig. 9** dargestellt an seiner durch die Folie **10** gebildeten Aussenflache **41** im Fixierungsbereich **14** eine kleine Delle **43** aufweisen Bei geeigneter Auswahl der Materialien und Dimensionen und geeigneter Durchführung des Herstellungsverfahrens ist es aber möglich, bei der Einbettung der Folie **10** in die Kunststoffmasse **42** die Folie **10** zusammen mit der Struktur **12** so zurückzuverformen, dass man eine praktisch intakte bzw. dellenfreie Aussenfläche **41** erhält. Zur Einbettung in die Kunststoffmasse **42** können verschiedene Verfahren verwendet werden; neben einem Laminierverfahren kommen insbesondere Verfahren in Frage, bei welchen die Kunststoffmasse **42** in einen die Folie **10** mit der Struktur **12** enthaltenden Formhohlraum eingebracht und verdichtet wird, also Einspritz-, Spritzgiess- und -pressverfahren und Spritzprägeverfahren.

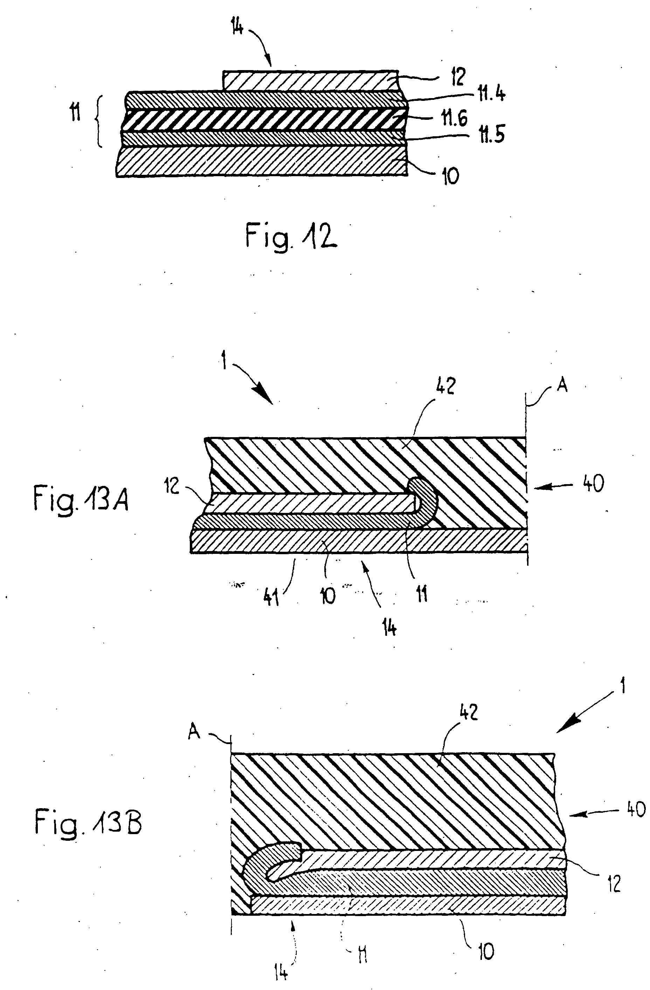

Die **Fig. 10A** und **11A** zeigen weitere Anordnungen einer Folie **10** und einer Struktur **12** vor der Fixierung der Struktur **12** an der Folie **10,** und in den **Fig. 10B** bzw. **11B** sind dieselben Folien **10** und Strukturen **11** nach der Fixierung dargestellt. Aus den **Fig. 10B** und **11B** ist auch die Vorrichtung zur Fixierung ersichtlich, die im wesentlichen den Vorrichtungen gemäss den **Fig. 7** und **8** entspricht, wobei ihre einzelnen Teile auch mit denselben Bezugszeichen versehen sind wie in den **Fig. 7** und **8.** Die Beispiele der **Fig. 10B** und **11B** zeigen die Fixierung der Struktur **12** an der Folie **10** mittels einer die Folie **10** nicht durchstossenden Verbindungstechnik, welche auf der Weichmachung oder Schmelzung der Folie **10** beruht. Dabei entstehende Eindellungen können nach der Einbettung von Folie **10** und daran fixierter Struktur in die zur Bildung des Kunststoffobjektes dienenden Kunststoffmasse durch eine Verdichtung der Kunststoffmasse mindestens teilweise rückgängig gemacht werden.

Die **Fig. 12** zeigt einen Kontaktierbereich **14** mit einer Leiterbahn **11** in Form eines FPC, die zwei leitende Schichten **11.4, 11.5** besitzt, welche durch eine Isolationsschicht **11.6** getrennt sind. Die Kontaktierung hat in diesem Falle nicht nur den Zweck, die eine oder beide der leitenden Schichten **11.4, 11.5** mit der Struktur **12** zu verbinden, sondern auch die beiden leitenden Schichten **11.4, 11.5** gegenseitig zu kontaktieren.

In den **Fig. 13A** und **13B** sind als Beispiel für Kunststoffobjekte Chipkarten **40** dargestellt, die als Elektronikbauteil je ein Elektronikmodul enthalten. Durch die Kontaktierung der Struktur **12** des Elektronikmoduls mit der Leiterbahn **11** und die gleichzeitige gegenseitige Fixierung von Folie **10.** Leiterbahn **11** und Struktur **12** erhält man die einfach herstellbare und solide Kontaktfolie **1** Bei der Chipkarte **40** gemass Fig. **13A** ist bei der Herstellung der Kontaktfolie **1** die Deformation ohne Perforation der Folie **10** erfolgt wahrend bei der Chipkarte **40** gemäss **Fig. 13B** die Kontaktfolie **1** mit Perforation ihrer Folie **10** erfolgt ist. Das fertige Kunststoffobjekt **40** gemäss **Fig. 13A** kann an seiner durch die Kontaktfolie **1** gebildeten Aussenfläche **41** im Kontaktierbereich **14** eine kleine Delle aufweisen, die aber im allgemeinen beim Einbetten der Kontaktfolie **1** in die Kunststoffmasse **42** wieder zurückverformt wird, wie dias in **Fig. 13A** dargestellt ist. Auch beim Kunststoffobjekt **40** gemäss **Fig. 13B** erhält man bei geeigneter Auswahl der Materialien und Dimensionen und geeigneter Durchführung des Herstellungsverfahrens nach der Einbettung der Kontaktfolie **1** in die Kunststoffmasse **42** folienseitig eine einwandfreie Fläche, wobei das Einbetten bei den Kunststoffobjekten sowohl gemäss **Fig. 13A** wie auch gemäss **Fig. 13B** beispielsweise durch Einspritzen von Kunststoffmasse **42** in einen die Kontaktfolie **1** enthaltenden Formhohlraum bzw. durch Verdichten der eingespritzten Kunststoffmasse beim Spritzgiessen oder -prägen durchgeführt werden kann, während in anderen Fällen das Einbetten auch durch Laminierung erfolgen kann.

## Patentansprüche

1. Verfahren zur Herstellung eines ein Elektronikbauteil und eine Folie (10) enthaltenden Kunststoffobjektes (40), wobei das Elektronikbauteil eine Struktur (12) umfasst, **dadurch gekennzeichnet, dass** ein Teil der Struktur (12) des Elektronikbauteils in einem Fixierungsbereich (14) durch Dehnung, Ausbiegung und Perforierung der Folie (10) mechanisch an der Folie (10) fixiert wird.

2. Verfahren nach Patentanspruch 1, **dadurch gekennzeichnet, dass** die Fixierung der Folie (10) ihre Weichmachung oder mindestens teilweise Schmelzung durch Energieeinkopplung von externer Wärme oder interner Reibungswärme einschliesst.

3. Verfahren nach Patentanspruch 1 oder 2, **dadurch gekennzeichnet, dass** die Struktur (12) des Elektronikmoduls im Fixierungsbereich (14) einen allseitig berandeten Durchbruch (18) oder einen vom Strukturrand ausgehenden Wegbruch (18) aufweist.

4. Verfahren nach mindestens einem der Patentansprüche 1 bis 3, **dadurch gekennzeichnet, dass** gleichzeitig mit der Fixierung der Struktur (12) und im gleichen Fixierungsbereich (14) eine weitere elektrisch leitende, vorzugsweise deformierbare, Leiterstruktur an der Folie (10) fixiert wird, so dass die Struktur (12) und die Leiterstruktur elektrisch verbunden und an der Folie (10) fixiert sind.

5. Verfahren nach Anspruch 4, **dadurch gekennzeichnet, dass** der zu deformierende Bereich (11.2) der Leiterstruktur (11) kreuzend zu einem elektrisch leitenden Kantenbereich (12.1) der Struktur (12) verläuft und dass die Folie (10) und die Leiterstruktur (11) mittels einer externen Werkzeugeinrichtung (24, 30) gemeinsam deformiert werden, um die Kontaktstrecke (11.1) der Leiterstruktur (11) am Kantenbereich (12.1) der Struktur (12) zur Anlage zu bringen.

6. Verfahren nach Patentanspruch 4 oder 5, **dadurch gekennzeichnet, dass** die Leiterstruktur (11), welche eine oder mehrere, jeweils durch eine Isolationsschicht (11.6) voneinander getrennte, leitende Schichten (11.4, 11.5) umfasst, vor ihrer Deformation an der Folie (10) befestigt wurde.

7. Verfahren nach mindestens einem der Patentansprüche 5 oder 6, **dadurch gekennzeichnet, dass** der Kantenbereich (12.1) ein Kantenbereich eines allseitig berandeten Durchbruchs oder eines mit der Berandung der Struktur (12) verbundenen Wegbruchs der Struktur (12) ist.

8. Verfahren nach mindestens einem der Patentansprüche 1 bis 7, **dadurch gekennzeichnet, dass** der zu deformierende Teil der Leiterbahn (11) vor seiner Ausbiegung aüs der Leiterbahnebene in der Leiterbahnebene derart gebogen angeordnet ist, dass er den leitenden Kantenbereich (12.1) der Struktur (12) mindestens ein weiteres Mal kreuzt, um nach der Deformation mindestens eine weitere Kontaktstrecke (11.1) zu bilden.

9. Verfahren nach mindestens einem der Patentansprüche 1 bis 8, **dadurch gekennzeichnet, dass** die Folie (10) in Kunststoff (42) eingebettet wird oder dass mindestens eine weitere Folie auf die Folie (10) auflaminiert wird.

## Claims

1. A method for producing a plastic object (40) containing an electronic component and a foil (10), the electronic component comprising a structure (12) **characterized in that** a portion of the structure (12) of the electronic component is mechanically fixed on the foil (10) in a fixation area (14) by means of stretching, bending and perforating.

2. A method in accordance with claim 1, **characterized in that** the fixation of the foil (10) includes its softening or at least partial melting by supplying energy in form of external heat or internal friction heat.

3. A method in accordance with claim 1 or 2, **characterized in that** in the fixation area the structure (12) of the electronic module has an opening (18) with an edge all around it or a break-away (18) starting from an edge of the structure.

4. A method in accordance with at least one of claims 1 - 3, **characterized in that** a further electrically conductive, preferably deformable, structure is fixed on the foil (10) in the same fixation area (14) simultaneously with the fixation of the structure (12), so that the structure (12) and the electrically conductive structure are connected electrically and fixed on the foil (10).

5. A method in accordance with claim 4, **characterized in that** the section (11.2) of the electrically conductive structure (11), which is to be deformed, extends crossing an electrically conducting edge area (12.1) of the structure (12), and that the foil (10) and the electrically conductive structure (11) are deformed together by means of an external tool (24, 30) in order to bring the contact section (11.1) of the electrically conductive structure (11) to rest against the edge area (12.1) of the structure (12).

6. A method in accordance with claim 4 or 5, **characterized in that**, prior to the deformation of the foil (10), the electrically conductive structure (11), which comprises one or more conducting layers (11.4, 11.5) separated from each other by an insulation layer (11.6), is fastened to the foil (10).

7. A method in accordance with at least one of claims 5 or 6, **characterized in that** the edge area (12.1) is an edge area of an opening with an edge all around it or of a break-away of the structure (12) connected to an edge of the structure (12).

8. A method in accordance with at least one of claims 1 to 7, **characterized in that** prior to being bent out of the plane of the electrically conductive structure, the portion of the electrically conductive structure (11) which is to be deformed is arranged in the plane of the electrically conductive structure in such a way that it crosses the conducting edge area (12.1) of the structure (12) at least one more time in order to constitute at least one further contact section (11.1) after deformation.

9. A method in accordance with at least one of claims 1 to 8, **characterized in that** the foil (10) is embedded in plastic (42) or that at least one further foil is laminated on the foil (10).

## Revendications

1. Procédé de production d'un objet plastique (40) contenant un composant électronique et une feuille (10), ledit composant électronique comprenant une structure (12), **caractérisé en ce qu'**une partie de la structure (12) du composant électronique est fixée mécaniquement à la feuille (10) dans une zone de fixation (14) par allongement, pliage et perforation de la feuille (10).

2. Procédé suivant la revendication 1, **caractérisé en ce que** la fixation de la feuille (10) inclut son ramollissement ou au moins en partie sa fusion par apport d'énergie provenant de chaleur externe ou de chaleur interne due au frottement.

3. Procédé suivant la revendication 1 ou 2,
**caractérisé en ce que** la structure (12) du module électronique présente dans la zone de fixation (14) une ouverture (18) bordée de tous côtés ou une percée (18) partant du bord de la structure.

4. Procédé suivant au moins l'une des revendications 1 à 3, **caractérisé en ce que**, simultanément avec la fixation de la structure (12) et dans la même zone de fixation (14), une autre structure de conducteur conduisant l'électricité, de préférence déformable, est fixée sur la feuille (10), de telle sorte que la structure (12) et la structure du conducteur sont reliées électriquement et sont fixées sur la feuille (10).

5. Procédé suivant la revendication 4, **caractérisé en ce que** la zone à déformer (11.2) de la structure du conducteur (11) forme une croix avec une zone du chant (12.1) conduisant l'électricité de la structure (12) et **en ce que** la feuille (10) et la structure du conducteur (11) sont déformées ensemble au moyen d'un outillage externe (24, 30) afin d'amener le tronçon de contact (11.1) de la structure du conducteur (11) contre la zone de chant (12.1) de la structure (12).

6. Procédé suivant la revendication 4 ou 5,
**caractérisé en ce que** la structure du conducteur (11), qui comprend une ou plusieurs couches conductrices (11.4, 11.5) séparées l'une de l'autre par une couche isolante (11.6), a été fixée sur la feuille (10) avant sa déformation.

7. Procédé suivant au moins l'une des revendications 5 ou 6, **caractérisé en ce que** la zone de chant (12.1) est une zone de chant d'une ouverture bordée de tous côtés ou d'une percée de la structure (12) reliée avec la bordure de la structure (12).

8. Procédé suivant au moins l'une des revendications 1 à 7, **caractérisé en ce que** la partie à déformer du trajet du conducteur (11), qui est en dehors du plan du trajet du conducteur avant d'être pliée, est située après pliage dans le plan du trajet du conducteur de manière qu'elle croise au moins une autre fois la zone de chant conductrice (12.1) de la structure (12) pour former après la déformation au moins un autre tronçon de contact (11.1).

9. Procédé suivant au moins l'une des revendications 1 à 8, **caractérisé en ce que** la feuille (10) est noyée dans le plastique (42) ou qu'au moins une autre feuille est laminée sur la feuille (10).
